Europäisches Patentamt

European Patent Office

Office européen des brevets

(11) Veröffentlichungsnummer: **0 013 335**
**A1**

# EUROPÄISCHE PATENTANMELDUNG

(21) Anmeldenummer: **79104859.8**

(22) Anmeldetag: **04.12.79**

(51) Int. Cl.³: **H 01 B 7/08**
**H 01 R 23/66, H 05 K 13/06**

(30) Priorität: **15.01.79 DE 2901416**

(43) Veröffentlichungstag der Anmeldung:
**23.07.80 Patentblatt 80/15**

(84) Benannte Vertragsstaaten:
**BE CH DE FR GB IT**

(71) Anmelder: **VDO Adolf Schindling AG**
**Gräfstrasse 103**
**D-6000 Frankfurt/Main(DE)**

(72) Erfinder: **Hahlganss, Günter**
**Breslauer Strasse 29**
**D-6239 Kriftel(DE)**

(74) Vertreter: **Könekamp, Herbert, Dipl.-Ing.**
**Sodener Strasse 9**
**D-6231 Schwalbach(DE)**

(54) Anordnung zum elektrischen Verbinden einer Vielzahl von Anschlüssen.

(57) Zum elektrischen Verbinden einer Vielzahl von dicht beieinander leigenden Anschlüssen eines Displays (1) mit einer Leiterplatte (20) sind flexible Leiterplatten (9,10,11) vorgesehen, von denen jede einer bestimmten Anzahl von Display-Anschlüssen zugeordnet ist. Der Abstand der Leiterbahnen zueinander vergrößert sich mit zunehmender Entfernung vom Display (1) bis zu einem vorgegebenen Leiterplattenrastermaß (16). Eine solche Verbindung gestattet eine besonders platzsparende Ausführung der Leiterplatte, mit der das Display verbunden werden soll und ist zudem leicht herstellbar.

FIG.1

FIG.2a    FIG.2b    FIG.2c

EP 0 013 335 A1

0013335

VDO Adolf Schindling AG        - 1 -        6000 Frankfurt/Main
                                            Gräfstraße 103

## Anordnung zum elektrischen Verbinden einer Vielzahl von Anschlüssen

Die Erfindung bezieht sich auf eine Anordnung zum elektrischen Verbinden einer Vielzahl von dicht beieinander liegenden Anschlüssen einer elektronischen Baugruppe, insbesondere eines Displays, mit den Anschlüssen einer der Baugruppe zugeordneten Ansteuerelektronik, die sich auf Leiterplatten befinden, unter Zwischenschaltung eines elektrisch leitenden, gummielastischen Elements.

Es ist bereits bekannt, die Anschlüsse eines Displays, beispielsweise eines Flüssigkristalldisplays, eines Vakuumfluoreszenzdisplays oder dergleichen, mit den Leiterbahnen einer die Ansteuerelektronik für das Display tragende Leiterplatte dadurch zu verbinden, daß zwischen den Anschlüssen des Displays und den Leiterbahnen ein sogenannter Leitgummikörper angeordnet und die Anschlüsse und Leiterbahnen gegen diesen gedrückt werden. Der Leitgummikörper besteht aus einer Vielzahl von sich über die Körperdicke erstreckenden, elektrisch leitenden faserartigen Kontaktelementen, die mit seitlichem Abstand zueinander in einem gummielastischen Isoliermaterial eingebettet sind. Die Leiterbahnen, die im Bereich der Anschlüsse des Flüssigkristalldisplays

- 2 -

in gleicher hoher Dichte wie die Anschlüsse nebeneinander liegen, spreizen sich mit zunehmender Entfernung vom Bereich der Anschlüsse einen größer werdenden Abstand zwischen sich einnehmend auf, dergestalt, daß diskrete Bauelemente, wie Transistoren, Widerstände, Kondensatoren oder auch IC-Bausteine (integrated circuits) ohne Schwierigkeiten an ihre freien Enden angelötet werden können. Diese zum Anschließen der diskreten Bauelemente erforderliche Aufspreizung der Leiterbahnen führt bei Displays mit einer Vielzahl von in einer Reihe nebeneinander liegenden Anschlüssen zu Leiterplattenabmessungen, die in dem für das Anschließen der Bauelemente vorgesehenen Bereich in Richtung der Displayanschlußreihe um ein Mehrfaches größer sind als die Länge der Displayanschlußreihe und mithin nur schwer oder gar überhaupt nicht in einem Displaygehäuse vernünftiger Größe untergebracht werden können.

Diese Nachteile sollen durch die Erfindung überwunden werden. Es ist daher Aufgabe der Erfindung, aufbauend auf einer Anordnung der eingangs beschriebenen Gattung eine Verbindungsanordnung zu schaffen, die bei leichter Herstellbarkeit der Verbindung einen möglichst geringen Platzbedarf benötigt.

Diese Aufgabe wird erfindungsgemäß dadurch gelöst, daß jeweils ein Teil der Anschlüsse der Baugruppe einer flexiblen Leiterplatte zugeordnet ist, die sich von einem Mittelteil mit den einzelnen Anschlüssen zugeordneten Leiterbahnen in mindestens einen der Ansteuerelektronik zugeordneten Randbereich unter Vergrößerung des Abstandes der einzelnen Leiterbahnen erweitert.

Durch diese Maßnahmen wird erreicht, daß die den diskreten

0013335

Bauelementen zugeordneten Teile der flexiblen Leiterplatten sich zumindest in Teilbereichen überlappen, so daß die Gesamtausdehnung der Leiterplatten im Bereich der diskreten Bauelemente in Richtung der Displayanschlüsse klein gehalten werden kann. Die mit diskreten Bauelementen bestückten Teile der flexiblen Leiterplatten lassen sich aufgrund ihrer Flexibilität ohne Schwierigkeiten in großer Packungsdichte hinter dem Display anordnen. Ein besonderer Vorteil der Erfindung besteht darin, daß die erfindungsgemäße Verbindungsanordnung im Vergleich zu der bekannten ohne Mehraufwand realisiert werden kann.

Gemäß einer vorteilhaften Ausführungsform der Erfindung erweitert sich jede Leiterplatte in zwei den diskreten Bauelementen zugeordnete äußere Bereiche. Dadurch ergibt sich ein besonders geringer Platzbedarf der Verbindungsanordnung, dies im übrigen auch dann, wenn die dicht beieinander liegenden Anschlüsse der elektronischen Baugruppe nur auf einer Seite derselben angeordnet sind.

Zur Erzielung einer raschen und problemfreien Festlegung der diskreten Bauelemente auf den Leiterplatten empfiehlt es sich, in jedem äußeren Bereich einer Leiterplatte den Abstand der einzelnen Leiterbahnenden entsprechend einem üblichen Rastermaß zu wählen.

Als besonders zweckmäßig hat es sich erwiesen, einer elektronischen Baugruppe drei flexible Leiterplatten zuzuordnen, von denen eine sich zu ihrer Längsachse symmetrisch vom Mittelteil zu jedem äußeren Bereich erweitert, eine sich nur auf der einen Seite vom Mittelteil zu jedem äußeren Bereich erweitert und eine sich nur auf der anderen Seite vom Mittelteil zu jedem äußeren Bereich erweiternd ausgebildet ist und die alle drei

- 4 -

in ihrem äußeren Bereich eine der Länge der elektronischen
Baugruppe entsprechende Breite aufweisen. Eine solche Ausführungsform besitzt einen vergleichsweise besonders geringen Raumbedarf, wobei gleichzeitig die Montage der diskreten
Bauelemente auf den äußeren Leiterplattenbereichen besonders
einfach ist. Letzteres ist darauf zurückzuführen, daß
die äußeren Bereiche der Leiterplatten ohne Behinderung relativ zueinander bewegt werden können. Bei langgestreckten
elektronischen Baugruppen sind am zweckmäßigsten einzelnen
Baugruppenabschnitten jeweils drei flexible Leiterplatten
des vorgenannten Zuschnitts zugeordnet. An und für sich
können auch bei langgestreckten elektronischen Baugruppen
jeder Baugruppe lediglich drei flexible Leiterplatten des
vorgenannten Zuschnitts zugeordnet werden, jedoch ist dann
die Handhabung dieser verhältnismäßig großen flexiblen
Leiterplatten etwas ungünstiger als bei der zuvor beschriebenen Ausführungsform.

Gemäß einer vorteilhaften Ausführungsform der Erfindung sind
die flexiblen Leiterplatten auf einer die elektronische
Baugruppe tragenden Montageplatte festgelegt. Eine solche
Montageplatte ist insbesondere bei Flüssigkristalldisplays
bereits vorhanden und dient unter anderem zur Halterung
einer Lichtquelle, beispielsweise in Form eines Lichtleiters,
die auf der dem Betrachter abgewandten Seite des Displays
angeordnet ist. Zur Fixierung der einzelnen einer elektronischen Baugruppe zugeordneten flexiblen Leiterplatte
zueinander und in bezug auf die elektronische Baugruppe
trägt am zweckmäßigsten die Montageplatte Zentrierzapfen,
die in entsprechende Löcher in den flexiblen Leiterplatten
eingreifen. Zusätzlich oder auch stattdessen können die
Montageplatte und die flexiblen Leiterplatten miteinander
verklebt sein. Gemäß einer vorteilhaften Ausführungsform
kann die Montageplatte aus Kunststoff bestehen und die

0013335

flexiblen Leiterplatten können durch Heißsiegeln miteinander und mit der Montageplatte verbunden sein. Eine solche Ausführungsform bietet gegenüber den anderen Ausführungsformen insbesondere montagetechnische Vorteile.

Um eine gute Beweglichkeit der einzelnen flexiblen Leiterplatten relativ zueinander sicherzustellen, empfiehlt es sich, die Breite des Mittelteils jeder Leiterplatte größer als die Breite der Montageplatte zu wählen. Andernfalls kann es geschehen, daß insbesondere bei der zuvor beschriebenen Ausführungsform mit drei Leiterplatten pro Baugruppe bzw. Baugruppenabschnitt sich die Leiterplatten im Bereich der Montageplatte untereinander verhaken, hochstehen und nur mit entsprechender Krafteinwirkung wieder in ihre flächige Ausgangslage gebracht werden können.

Als zweckmäßig hat es sich darüber hinaus erwiesen, die äußeren Bereiche der flexiblen Leiterplatten mit Zentrierlöchern zu versehen. Dies gestattet eine besonders schnelle und exakte Verbindung der äußeren Bereiche der flexiblen Leiterplatte mit den Leiterbahnen auf einer starren Leiterplatte, wenn diese mit in die Zentrierlöcher eingreifenden Zapfen versehen ist. Eine solche Ausführungsform ist insbesondere auch dann von Vorteil, wenn die flexiblen Leiterplatten lediglich als elektrische Verbindungselemente zwischen den Anschlüssen an den elektronischen Baugruppen und entsprechenden Anschlüssen auf der entsprechenden starren Leiterplatte dienen.

Die Erfindung sei anhand der Zeichnung, die in zum Teil schematischer Darstellung ein Ausführungsbeispiel enthält, näher erläutert. Es zeigen

    Figur 1 eine Seitenansicht einer Flüssigkristallzelle,
               deren Anschlüsse mit drei flexiblen Leiterplatten
               in Verbindung stehen,

Figur 2a  eine Aufsicht auf eine der drei flexiblen Leiterplatten gemäß Figur 1,

Figur 2b  eine Aufsicht auf eine andere der drei flexiblen Leiterplatten gemäß Figur 1,

Figur 2c  eine Aufsicht auf eine weitere der drei flexiblen Leiterplatten gemäß Figur 1 und

Figur 3  eine Rückansicht auf die Flüssigkristallzelle-Leiterplatten-Einheit.

Die Flüssigkristallzelle 1, die lediglich schematisch dargestellt ist, besteht aus den beiden Zellengläsern 2 und 3, zwischen denen sich die Flüssigkristallsubstanz 4 befindet. Die auf den beiden Zellengläsern 2 und 3 angeordneten Elektroden sind nicht sichtbar. Diese Elektroden sind an den Stellen 5 zugänglich und stehen über jeweils einen Leitgummistrang 6 bzw. 7 mit den als Anschlüsse ausgebildeten Leiterbahnenden 8 auf den drei flexiblen Leiterplatten 9, 10 und 11 in leitender Verbindung. In dem von den Leitgummisträngen 6 und 7, dem Zellglas 3 und den flexiblen Leiterplatten 9, 10 und 11 gebildeten Raum 12 befindet sich ein Lichtleiter 13, über den die Rückseite der Flüssigkristallzelle beleuchtbar ist.

Jede der drei Leiterplatten 9, 10 und 11 umfaßt jeweils zwei äußere Bereiche 14 und 15 und einen Mittelteil 16, mit dem sich die als Anschlüsse ausgebildeten Leiterbahnenden 8 befinden. In den äußeren Bereichen 14 und 15 sind die den Leiterbahnenden 8 abgewandten Leiterbahnenden 16 in einem größeren Abstand zueinander angeordnet als im Mittelteil, wobei ihre Anordnung in einem üblichen Rastermaß vorgesehen ist.

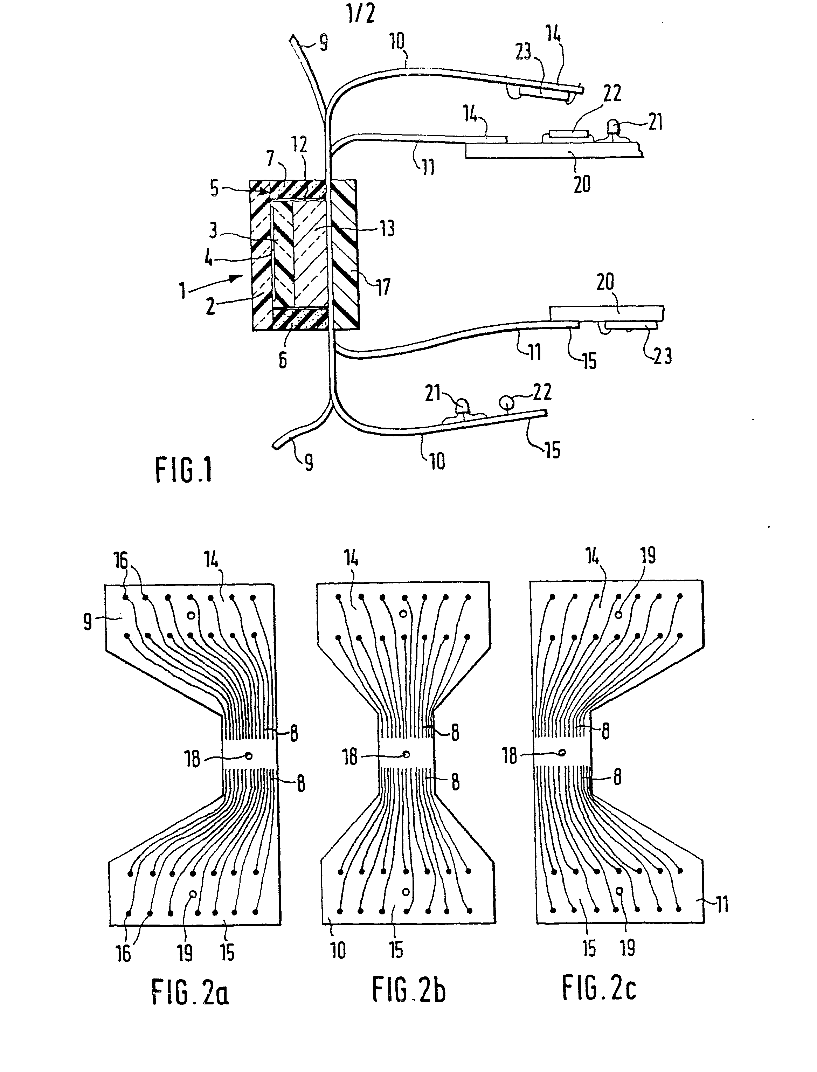

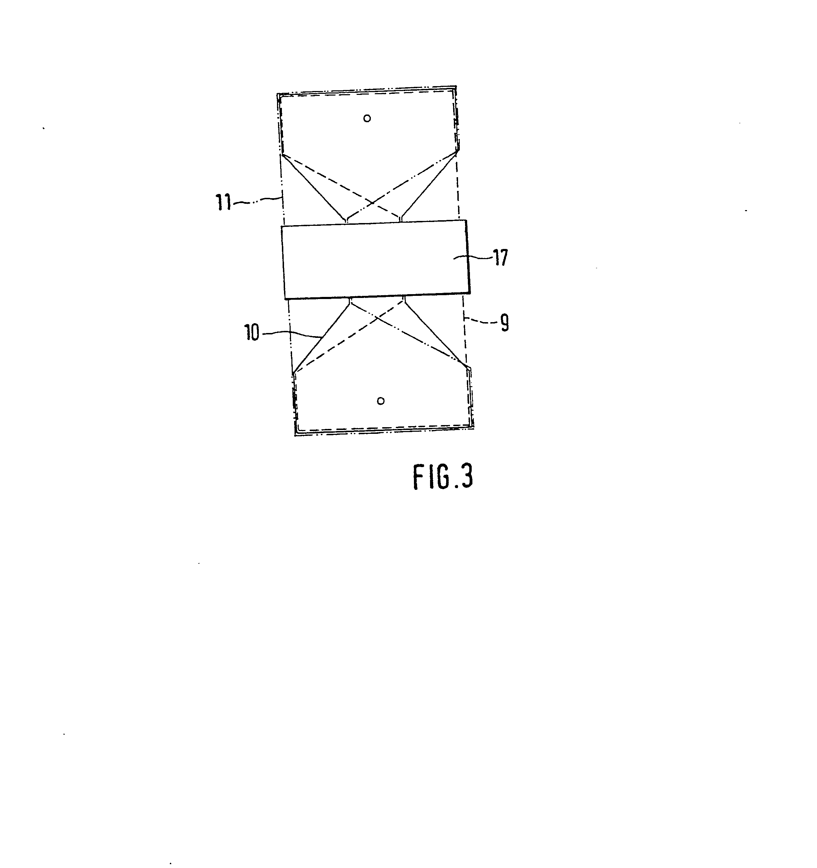

Wie insbesondere aus den Figuren 2a bis 2c in Verbindung mit Figur 3 ersichtlich ist, sind die drei Leiterplatten 9, 10 und 11 so ausgebildet, daß ihre Gesamtbreite im Mittelteil etwa gleich der Länge der Flüssigkristallzelle 1 entspricht, während sie alle drei in ihren äußeren Bereichen 14 bzw. 15 eine der Länge der Flüssigkristallzelle 1 entsprechende Breite aufweisen.

Zur genauen Fixierung der drei Leiterplatten 9, 10 und 11 zueinander und zu den Leitgummisträngen 6 und 7 ist eine Montageplatte 17 vorgesehen, die mit nicht näher dargestellten Zentrierzapfen versehen ist, die in entsprechende Löcher 18 in den Leiterplatten 9, 10 und 11 eingreifen. Die Montageplatte 17 besteht aus Kunststoff und ist mit den drei flexiblen Leiterplatten 9, 10 und 11 durch Heißsiegeln verbunden. Um eine ungehinderte Bewegung der äußeren Leiterplattenbereiche 14 und 15 der drei Leiterplatten relativ zueinander sicherzustellen, ist die Breite des Mittelteiles jeder Leiterplatte größer ausgebildet als die Breite der Montageplatte 17, wie sich insbesondere der Figur 3 entnehmen läßt.

Die äußeren Bereiche 14 und 15 der flexiblen Leiterplatten 9, 10 und 11 sind ebenfalls mit Zentrierlöchern 19 versehen, in die an Leiterplatten 20 angeformte Zentrierzapfen eingreifen können. Anstelle einer Verbindung der äußeren Bereiche 14 und 15 der drei flexiblen Leiterplatten mit starren Leiterplatten 20 können auch unmittelbar auf die flexiblen Leiterplatten 9, 10 und 11 diskrete Bauelemente, wie Transistoren 21, Widerstände 22 oder IC's 23 aufgesetzt und deren Anschlüsse mit den Leiterbahnen verlötet sein.

## Patentansprüche

1. Anordnung zum elektrischen Verbinden einer Vielzahl von dicht beieinander liegenden Anschlüssen einer elektronischen Baugruppe, insbesondere eines Displays, mit den Anschlüssen einer der Baugruppe zugeordneten Ansteuerelektronik, die sich auf Leiterplatten befindet, unter Zwischenschaltung eines elektrisch leitenden, gummielastischen Elements, dadurch gekennzeichnet, daß jeweils ein Teil der Anschlüsse der Baugruppe (1) einer flexiblen Leiterplatte (9,10,11) zugeordnet ist, die sich von einem Mittelteil mit den einzelnen Anschlüssen zugeordneten Leiterbahnen (8) in mindestens einen der Ansteuerelektronik (21,22,23) zugeordneten äußeren Bereich (14,15) unter Vergrößerung des Abstandes der einzelnen Leiterbahnen erweitert.

2. Anordnung nach Anspruch 1, dadurch gekennzeichnet, daß jede Leiterplatte (9,10,11) sich in zwei äußere Bereiche (14,15) erweitert.

3. Anordnung nach Anspruch 1 oder 2, dadurch gekennzeichnet, daß in jedem äußeren Bereich (14,15) einer Leiterplatte (9,10,11) der Abstand der einzelnen Leiterbahnenden (16) einem üblichen Rastermaß entspricht.

4. Anordnung nach einem der Ansprüche 1 bis 3, dadurch gekennzeichnet, daß einer elektronischen Baugruppe (1) drei flexible Leiterplatten (9,10,11) zugeordnet sind, von denen eine (10) sich zu ihrer Längsachse symmetrisch vom Mittelteil zu jedem äußeren Bereich (14,15) erweiternd eine (9) sich nur auf der einen Seite vom Mittelteil zu jedem äußeren Bereich (14,15) erweiternd und

0013335

eine (11) sich nur auf der anderen Seite vom Mittelteil zu jedem äußeren Bereich (14,15) erweiternd ausgebildet ist und die alle drei in ihrem äußeren Bereich (14,15) eine der Länge der elektronischen Baugruppe (1) entsprechende Breite aufweisen.

5. Anordnung nach Anspruch 4, dadurch gekennzeichnet, daß bei langgestreckten elektronischen Baugruppen (1) einzelnen Baugruppenabschnitten jeweils drei flexible Leiterplatten (9,10,11) zugeordnet sind.

6. Anordnung nach einem der Ansprüche 1 bis 5, dadurch gekennzeichnet, daß eine Montageplatte (17) vorgesehen ist, auf der die flexiblen Leiterplatten (9,10,11) und die elektronische Baugruppe (1) festgelegt sind.

7. Anordnung nach Anspruch 6, dadurch gekennzeichnet, daß die Montageplatte (17) in entsprechende Löcher (18) in den flexiblen Leiterplatten (9,10,11) eingreifende Zentrierzapfen trägt.

8. Anordnung nach Anspruch 6 oder 7, dadurch gekennzeichnet, daß die Montageplatte (10) und die flexiblen Leiterplatten (9,10,11) miteinander verklebt sind.

9. Anordnung nach Anspruch 6 oder 7, dadurch gekennzeichnet, daß die Montageplatte (17) aus Kunststoff besteht und die flexiblen Leiterplatten (9,10,11) durch Heißsiegeln miteinander verbunden sind.

10. Anordnung nach einem der Ansprüche 6 bis 9, dadurch gekennzeichnet, daß die Breite des Mittelteils jeder Leiterplatte (9,10,11) größer als die Breite der Montageplatte (17) ist.

- 3 -

11. Anordnung nach einem der Ansprüche 1 bis 10, dadurch ge-kennzeichnet, daß die äußeren Bereiche (14,15) der flexiblen Leiterplatten (9,10) mit Zentrierlöchern (19) versehen sind.

0013335

FIG.1

FIG.2a

FIG.2b

FIG.2c

FIG.3

![Europäisches Patentamt] **Europäisches Patentamt** **EUROPÄISCHER RECHERCHENBERICHT**

0013335

Nummer der Anmeldung

EP 79 10 4859

| EINSCHLÄGIGE DOKUMENTE | | | KLASSIFIKATION DER ANMELDUNG (Int.Cl.3) |
|---|---|---|---|
| **Kategorie** | Kennzeichnung des Dokuments mit Angabe, soweit erforderlich, der maßgeblichen Teile | betrifft Anspruch | |
| | GB - A - 1 350 540 (AMP) <br> * Seite 3, Zeilen 25 bis 56; <br> Fig. 7 und 8 * | 1-4 | H 01 B  7/08 <br> H 01 R 23/66 <br> H 05 K 13/06 |
| P | EP - A1 - 0 001 555 (SIEMENS) <br> * Seite 3, Zeilen 11 bis 32; Seite 4, <br> Zeile 12 bis Seite 5, Zeile 19; <br> Fig. 1 bis 3 * | 1,4 | |
| | | | **RECHERCHIERTE SACHGEBIETE (Int. Cl.3)** |
| | FEINWERKTECHNIK & MESSTECHNIK, <br> Band 86, Nr. 1, 1978 <br> J. GEINTZER " Flachkabelgarnituren <br> als modulare Zwischenverbindungen <br> in elektrischen Anlagen und Geräten" <br> * Seite 38, rechte Spalte, Zeilen <br> 17 bis 35; Fig. 6 * <br> * Seite 39; Fig. 11 * | 1,3 <br> 6 | H 01 B  7/08 <br> H 01 R 23/00 <br> H 05 K 13/06 |
| | FUNKTECHNIK, Band 32, Nr. 9, 1977, <br> "Flexible gedruckte Schaltungen zur <br> Problemlösung" <br> Seiten F&E 163 und 164 <br> * Seite F&E 164, Figur links oben; <br> rechte Spalte, Zeilen 33 bis 48 * | 1,3 | **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur <br> T: der Erfindung zugrunde <br>  liegende Theorien oder <br>  Grundsätze <br> E: kollidierende Anmeldung <br> D: in der Anmeldung angeführtes <br>  Dokument <br> L: aus andern Gründen <br>  angeführtes Dokument <br> &: Mitglied der gleichen Patent- <br>  familie,  übereinstimmendes <br>  Dokument |
| | ./.. | | |

| | | | | |
|---|---|---|---|---|
| X | Der vorliegende Recherchenbericht wurde für alle Patentansprüche erstellt. | | | |
| **Recherchenort** <br> Berlin | **Abschlußdatum der Recherche** <br> 17-04-1980 | | **Prüfer** <br> HAHN | |

# EUROPÄISCHER RECHERCHENBERICHT

| | EINSCHLÄGIGE DOKUMENTE | | | KLASSIFIKATION DER ANMELDUNG (Int.Cl.³) |
|---|---|---|---|---|
| Kategorie | Kennzeichnung des Dokuments mit Angabe, soweit erforderlich, der maßgeblichen Teile | | betrifft Anspruch | |
| A | <u>DE – A1 – 2 441 665</u> (KABELWERKE REINS-HAGEN) <br> * ganzes Dokument * <br><br> –– <br><br> <u>GB – A – 1 302 974</u> (BURROUGHS) <br> * Seite 1, Zeile 77 bis Seite 2, Zeile 18; Seite 2, Zeilen 56 bis 108; Fig. 1 bis 3 * <br><br> ––––– | | 1 | **RECHERCHIERTE SACHGEBIETE (Int. Cl.³)** |

EPA Form 1503.2   06.78